**Europäisches Patentamt**

**European Patent Office**

**Office européen des brevets**

(11) Publication number: **0 055 451**
**B1**

# EUROPEAN PATENT SPECIFICATION

(45) Date of publication of patent specification: **28.03.90**

(51) Int. Cl.⁵: **G 11 C 5/00**

(21) Application number: **81110659.0**

(22) Date of filing: **21.12.81**

(60) Divisional application 85110709 filed on 26.08.85.

(54) Semiconductor memory device.

(30) Priority: **26.12.80 JP 188723/80**

(43) Date of publication of application:
**07.07.82 Bulletin 82/27**

(45) Publication of the grant of the patent:
**28.03.90 Bulletin 90/13**

(84) Designated Contracting States:
**DE FR GB NL**

(56) References cited:
**DE-A-2 829 052**

**PATENTS ABSTRACTS OF JAPAN, vol. 4, no.
168 (P-37)650r, 20th November 1980 & JP A
55113189**

**PATENTS ABSTRACTS OF JAPAN, vol. 5, no. 99
(E-63)771r, 26th June 1981 & JP A 5642365**

**PATENTS ABSTRACTS OF JAPAN, vol. 6, no.
128 (E-118)1006r, 14th July 1982 & JP A 5754358**

**IRE NATIONAL CONVENTION RECORD; part 6,
1957, pages 3-10, New York US, C Brunetti: "A
new venture into micro-miniaturization"**

**ELECTRONICS RELIABILITY &
MICROMINIATURIZATION, vol 1, 1962, pages
97-98, Pergamon Press GB "A high voltage
photo-voltaic battery using a single silicon
wafer"**

(73) Proprietor: **HITACHI, LTD.**
**6, Kanda Surugadai 4-chome Chiyoda-ku
Tokyo (JP)**

(73) Proprietor: **Hitachi Maxell Ltd.
No 1-1-88, Ushitora Ibaraki-shi
Osaka-fu (JP)**

(72) Inventor: **Katsuki, Miyàuchi
7812-12, Hino Hino-shi
Tokyo (JP)**
Inventor: **Tetsuichi, Kudo
2-17-5, Oyamadai Setagaya-ku
Tokyo (JP)**
Inventor: **Osamu, Minato
1473-B6-3, Josuihoncho
Kodaira-shi Tokyo (JP)**
Inventor: **Toshiaki, Masuhara
2196-278, Hirai Hinodemachi
Nishitama-gun Tokyo (JP)**
Inventor: **Yoshio, Uetani
1-11-15, Nishi-ai Ibaragi-shi
Ohsaka-fu (JP)**

(74) Representative: **Strehl, Peter, Dipl.-Ing. et al
Patentanwälte Strehl Schübel-Hopf Groening
Maximilianstrasse 54 Postfach 22 14 55
D-8000 München 22 (DE)**

Courier Press, Leamington Spa, England.

**EP  0 055 451  B1**

(56) References cited:
**IBM TECHNICAL DISCLOSURE BULLETIN, vol
20, no 12, May 1978, pages 5201-5202, New York
US, R Brosch et al: "Integrated decoupling
capacitor"**

## Description

Background of the Invention

This invention relates to a semiconductor memory device.

As nonvolatile memories or read only memories (ROMs), there have heretofore been utilized an electrically erasable and programmable read only memory (EEPROM) and an electrically programmable read only memory (EPROM). These, however, have such disadvantages (1) that the writing time is long and (2) that since the writing voltage is high, a two-power-source system is needed. An EEPROM and an EPROM of 16 kb will be mentioned as examples. As power sources to be used, a 25V power source necessary for a programming mode and a 5V power source necessary for an access mode are required. Regarding the writing time, a long time of about 100 seconds is needed for writing all bits. In addition, the access time is as long as 450 ns, which is about 4 times the access time of a random access memory (RAM) having an equal capacity. This is attributed to the fact that, to the end of reducing the cell size, the ROM performs a static operation by the use of only one data line. The EPROM further involves the disadvantage that the memory content cannot be electrically erased.

On the other hand, there is the random access memory (RAM) as a memory capable of writing and reading at high speed in contrast to the read only memory (ROM). Although the memory cell of the RAM has a single data line as in the ROM, the operation thereof is dynamic and various signals can be generated in parallel. Since data can be sensed and amplified at high speed with the signals, the operating speed can be enhanced. When a memory of 16 kb is taken as an example, the access time of the RAM is about $\frac{1}{4}$ as compared with that of the ROM. In addition, the writing time is substantially the same as the access time.

With prior arts, however, the RAMs have the disadvantage that they cannot avoid becoming volatile memories. More specifically, in case of a dynamic RAM, a one-transistor MOS structure is the mainstream at present. With this structure, unless the memory is refreshed once very 2 msec., the memory content cannot be retained. When the power supply is turned "off", naturally the memory content disappears. In case of a static RAM whose memory cell is a flip-flop structure, the refreshing becomes unnecessary. However, when the power supply is turned "off" so that no current is supplied to the memory cell, the memory content cannot be retained as in the dynamic RAM.

JP—A—55—113 189 discloses a semiconductor device as set forth in the first part of claim 1. The known device is in the form of a plate on which volatile memory elements are mounted. A power supply is incorporated in a handle adapted to be attached to the plate, and the power supply may be connected by a cable to power supply terminals provided on the plate. The known device thus provides a data storing unit wherein the loss of information due to disconnection of the memory elements from their regular power supply is avoided.

It is further known from DE—A—2 829 052 to supply a semi-conductor device with electrical energy from a photocell on the surface of the device.

Summary of the Invention

It is an object of the invention to provide a semiconductor device including a volatile memory part, which is rendered non-volatile by an incorporated electric energy storing cell, and which is as compact and easy to manufacture as possible.

The semiconductor device characterized in claim 1 meets this object.

The fields of utilization of the nonvolatile semiconductor memory according to this invention are a memory part of a computer terminal equipment which uses a single small-sized power source, a microcomputer or a small-sized desk calculator which requires a nonvolatile memory, etc.

Brief Description of the Drawings

Figure 1 is a sectional view of the structure of an embodiment of this invention in which a C-MOS·RAM is laminated with a battery.

Figure 2A is a block diagram showing the circuit of a RAM.

Figure 2B is a block diagram showing the circuit of an embodiment of this invention.

Figure 3 is a sectional view of the structure of an embodiment of this invention in which a C-MOS·RAM is laminated with a solar battery.

Figure 4 is an exterior view of an embodiment of this invention in the state in which a small-sized battery prepared separately has been stacked and bonded onto a silicon chip.

Figure 5 is a partial sectional view of the silicon chip and the small sized battery in Figure 4.

Description of the Preferred Embodiments

Hereunder, a nonvolatile semiconductor memory containing a power supply element according to this invention will be described in detail in conjunction with embodiments.

Embodiment 1

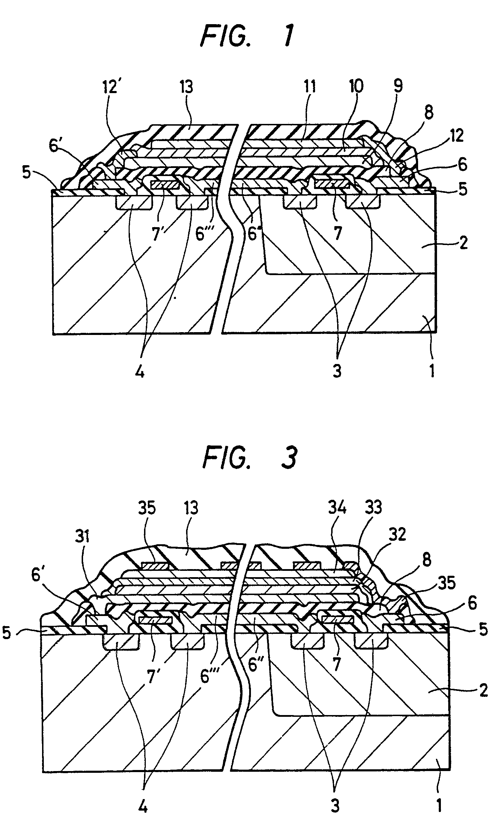

An example in which a fully solid-state battery is employed as a power supply element laminated on the chip of a RAM will be described with reference to Figure 1. In Figure 1, a passivation layer 8 of $Si_3N_4$ or the like is disposed on the surface of a C-MOS static RAM which is constructed of a silicon substrate 1 of the n-type conductivity, a well region 2 of the p-type conductivity, $n^+$-type conductivity regions 3, $p^+$-type conductivity regions 4, an insulating layer 5, metal interconnections 6, 6', 6'' and 6''' and gate electrodes 7 and 7'. On the layer 8, there are successively formed a conductive layer 9 for the anode or cathode of a battery, a solid electrolyte layer 10 and a conductive layer 11 for the cathode or anode of the battery. $TiS_2$, $VSe_2$ or the like is used as the anode material of the battery, while an Li—Al alloy, Li—Si alloy or the like is used as the cathode material. Used as the substance of the solid electrolyte is an $Li_4SiO_4$—$Li_3PO_4$ compound, $Li_3N$—LiI compound, $Li_3N$—LiI—LiOH compound, $LiNbO_3$ compound, $LiTaO_3$ compound or the like. The connection between the battery and the RAM chip is such that an earth terminal $V_{ss}$ 6 and a power supply terminal $V_{cc}$ 6' of a circuit integrated within a semiconductor are respectively connected to the anode and cathode through conductors 12 and 12'. Lastly, a passivation layer 13 is formed, and the chip is bonded and then packaged.

Owing to this structure, the cell capacity corresponding to the anode and cathode active materials of the battery determines the retention time of the RAM. For example, in case where a battery having a discharge capacity of 7 mAh is connected to a 16 kb C-MOS static RAM, the memory content is retained for about 30 days. In addition, since the battery is fully solid, it is stable and can possess a lifetime of at least 5 years. Further, since the battery indicated in the present embodiment is a secondary cell, it is charged while an external power source is turned "on", and the memory content can be retained by the discharge of the battery after the external power source has been turned "off".

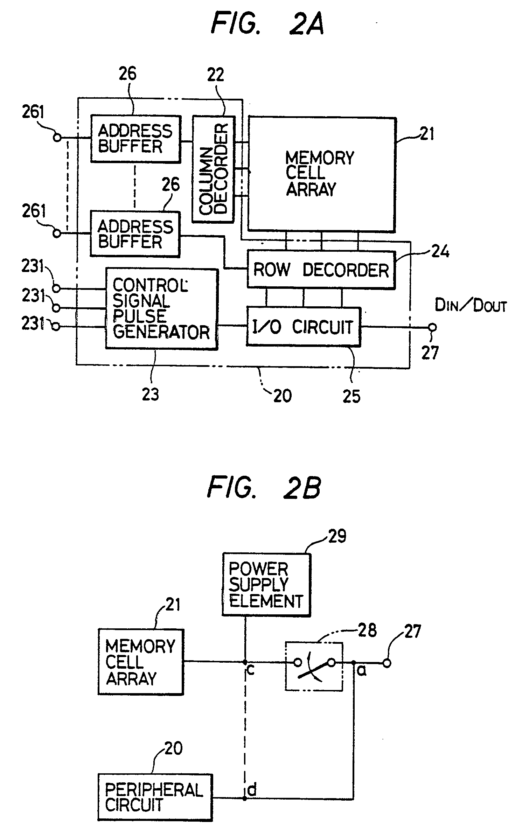

Now, a circuit for connecting the RAM and the battery in the present arrangement will be described with reference to block diagrams (Figures 2A and 2B). As shown in the block diagram of Figure 2A, the fundamental arrangement of the static RAM can be depicted by a memory cell array 21 and a peripheral circuit 20 (22: column decoder, 23: control signal pulse generator, 24: row decoder, 25: I/O circuit, 26: address buffer). In order to. retain the memory content, current is basically supplied from the power supply element to only the memory cell array. The construction of this invention for using the battery is shown in Figure 2B as the block diagram. In the construction, when the external power source (27: external power source terminal) is in its closed state, the memory cell array 21 and the peripheral circuit 20 fall into their operating states through a switching control circuit 28, and besides, the battery 29 is charged. On the other hand, when the external power source is in its open state, current is supplied to the memory cell array 21 by the battery 29 through the switching control circuit 28, and the memory content is retained, so that the RAM becomes nonvolatile.

Here, when the peripheral circuit has a circuit arrangement which does not consume current in a stand-by condition (for example, C-MOS circuit), it is also allowed to connect the power supply terminals c and d of the memory cell array and the peripheral circuit with the battery and to disconnect the path between the points a and d.

The switching control circuit 28 can be constructed of a combination of a supply voltage (current) sensing circuit, and control circuit and a switching circuit. It may well be inerlocked with a power supply switch or be made a mere switch.

Embodiment 2

An example in which a nonvolatile RAM is constructed by forming a p-i-n multilayer solar cell on a memory chip as a power supply element will be described with reference to Figure 3.

A current collector 31 is formed on a C-MOS static RAM chip which has a passivation layer 8 as in Embodiment 1. Subsequently, using amorphous silicon layers or polycrystalline silicon layers, semiconductor thin layers of the p-type 32, the i-type 33 and the n-type 34 are formed to construct the solar battery. Subsequently, a current collector 35 and a passivation film 13 are formed. After bonding the resultant chip, it is sealed in a package provided with a transparent window. Thus, a nonvolatile RAM is obtained. Here, the earth terminal $V_{ss}$ 6 and power source terminal $V_{cc}$ 6' of the circuit integrated in the semiconductor are respectively connected with the current collectors 31 and 35 of the solar cell.

The construction of the C-MOS static RAM chip is the same as in Embodiment 1. By dividing the solar cell into several regions on the chip and connecting them in series, any desired retention voltage can be generated.

With the element of the present embodiment, a current of at least 500 µA/cm$^2$ can be taken out in the presence of such light as the sunrays and the light of an electric lamp. In the presence of such light, therefore, the RAM functions as a semi-permanently nonvolatile RAM.

Embodiment 3

An example in which a fully solid-state battery, such as a lithium battery or a silver-zinc battery, is bonded on a memory chip will be described with reference to Figure 4.

On a memory chip 41 having already been subjected to the surface passivation, any of the aforecited batteries is fixed, whereupon the bonding of the memory chip and the bonding between the battery and the chip are carried out. Lastly, the resultant structure is pacakaged to construct the nonvolatile RAM (40: package, 401: lead, 402: pin). Here, numerals 42 and 43 designate the anode and cathode collectors of the battery which are connected with the power supply terminal $V_{cc}$ and earth terminal $V_{ss}$ of the circuit integrated in the memory chip, respectively. Numeral 44 indicates the sealing material of the battery. Figure 5 is a view of one section of a thin type battery fixed on the memory chip. Here, numeral 41 indicates a silicon integrated circuit chip, numerals 42 and 43 the anode and cathode collectors of the battery, numeral 44 the sealing material of the battery, numeral 45 is the body of the battery, numeral 46 a passivation film, numeral 47 a bonding pad, and numerals 48 and 48' connecting wires.

For example, in case where a battery having a discharge capacity of 7 mAh is connected to a 16 kb static RAM, the memory content is retained for about 30 days. In case of employing a fully solid-state battery, a long life of at least 5 years is attained.

The nonvolatile RAM according to this invention has the memory contents of its individual memory chips retained. Therefore, it has the advantages that a RAM can be freely sampled and moved from a memory board and that it can be shipped in the state in which an appropriate memory content is retained. Moreover, a useful memory system which is high in both the writing and reading speeds and which is nonvolatile as stated before can be constructed by the use of the RAM according to this invention.

In each of the foregoing embodiments, the RAM has been referred to as the memory of this invention. However, the invention is not restricted thereto, but it is also applicable to other volatile memories, for example, a content addressable memory (CAM), a serial memory and an analogue memory. It is a matter of course that the invention is applicable, not only to a MOS type memory, but also to a bipolar type memory.

## Claims

1. A semiconductor device comprising an integrated circuit chip formed on a semiconductor substrate (1) and including a memory part (3 ... 7) in which a plurality of volatile memory elements are arrayed, and at least one electric energy storing cell (9 ... 11; 31 ... 35) connected to power supply terminals (6, 6') of said integrated circuit chip, characterized in

that said chip is covered by a passivation film (8),

that said cell (9 ... 11; 31 ... 35) is a fully solid-state thin film battery and is laminated on the surface of said passivation film (8), and

that said integrated circuit chip and battery are packaged as a unit.

2. The device of claim 1, characterized in that said battery (9 ... 11) is a lithium secondary battery.

## Patentansprüche

1. Halbleitereinrichtung, umfassend ein auf einem Halbleitersubstrat (1) ausgebildetes integriertes Schaltungs-Chip mit einem Speicherteil (3 ... 7), in dem mehrere flüchtige Speicherelemente angeordnet sind, und mindestens eine mit Energieversorgungsklemmen (6, 6') des integrierten Schaltungs-Chips verbundene, elektrische Energie speichernde Zelle (9 ... 11; 31 ... 35), dadurch gekennzeichnet,

daß das Chip mit einem Passivierungsfilm (8) überzogen ist,

daß die Zelle (9 ... 11; 31 ... 35) eine auf die Oberfläche des Passivierungsfilms (8) laminierte, vollständig monolitische Dünnfilm-Batterie ist, und

daß das integrierte Schaltungs-Chip und die Batterie als Einheit gepackt sind.

2. Einrichtung nach Anspruch 1, dadurch gekennzeichnet, daß die Batterie (9 ... 11) eine Lithium-Sekundärbatterie ist.

## Revendications

1. Dispositif à semiconducteurs comportant une microplaquette à circuits intégrés formée sur un substrat semiconducteur (1) et comportant une partie formant mémoire (3 ... 7), dans laquelle une pluralité d'éléments de mémoire volatils sont rangés, et au moins une pile (9 ... 11; 31 ... 35) stockant une énergie électrique et raccordée à des bornes d'alimentation électrique (6, 6') de ladite microplaquette à circuits intégrés, caractérisé en ce

que ladite microplaquette est recouverte par une pellicule de passivation (8),

que ladite pile (9 ... 11; 31 ... 35) est une pile à couches minces entièrement à l'état solide et est disposée sur la surface de ladite pellicule de passivation (8), et

que ladite microplaquette à circuits intégrés et ladite pile sont mises en boîtier sous la forme d'une unité.

2. Dispositif selon la revendication 1, caractérisé en ce que ladite pile (9 ... 11) est une pile secondaire au lithium.

*FIG. 1*

*FIG. 3*

## FIG. 2A

## FIG. 2B